# EUROPÄISCHE PATENTSCHRIFT

(11) **EP 0 995 126 B1**
(45) Veröffentlichungstag und Bekanntmachung des Hinweises auf die Patenterteilung: **12.03.2003**
(21) Anmeldenummer: 98941254.9
(22) Anmeldetag: 30.06.1998
(51) Int. Cl.: G01S 7/03, H03B 9/12

(54) **KRAFTFAHRZEUG-RADARSYSTEM**
RADAR SYSTEM FOR MOTOR VEHICLE
SYSTEME RADAR POUR VEHICULE

(30) Priorität: 08.07.1997 DE 19729095
(43) Veröffentlichungstag der Anmeldung: 26.04.2000
(73) Patentinhaber: ROBERT BOSCH GMBH, 70442 Stuttgart (DE)
(72) Erfinder: MAYER, Hermann, D-71665 Vaihingen (DE); ENGELKE, Claus, D-70195 Stuttgart (DE)
(86) Internationale Anmeldenummer: DE9801792
(87) Internationale Veröffentlichungsnummer: WO99003002

(56) Entgegenhaltungen:
- WO-A-84/01243
- US-A- 4 543 577

## Beschreibung

Die vorliegende Erfindung betrifft ein Kraftfahrzeug-Radarsystem, mit einem Oszillator, der während des Betriebs des Radarsystems in Abhängigkeit eines Ansteuersignals nur zeitabschnittsweise ein Hochfrequenzsignal erzeugt und der eine Mikrowellendiode, insbesondere eine Gunn- oder Impattdiode umfaßt, die innerhalb eines gehäuseartigen Körpers untergebracht ist.

### Stand der Technik

Ein gattungsgemäßes Radarsystem ist beispielsweise aus der WO97/02496 bekannt. In dieser Schrift wird ein monostatischer FMCW-Radarsensor für ein Fahrzeug zur Detektion von Objekten beschrieben, bei dem wenigsten ein Antennenfeed in Verbindung mit einer dielektrischen Linse sowohl zum Senden als auch zum Empfangen eines entsprechenden Echosignals ausgebildet ist. Dieses gattungsgemäße Radarsystem wird nachfolgend anhand der Figuren 1 und 2 noch ausführlicher beschrieben. Gemäß der WO97/02496 kann die Sendeleistung des Oszillators ausgetastet werden, um den mittleren Energieaufwand oder mit anderen Worten die mittlere abgestrahlte Mikrowellensendeleistung zu verringern. Diesbezüglich nähert sich die Betriebsweise dieses FMCW-Radarsensors der eines Pulsradars. In einem konkreten Anwendungsfall erfolgt die Austastung des Oszillators beispielsweise in einem Taktverhältnis von 90 Millisekunden Pause zu jeweils 10 Millisekunden Sendezeit.

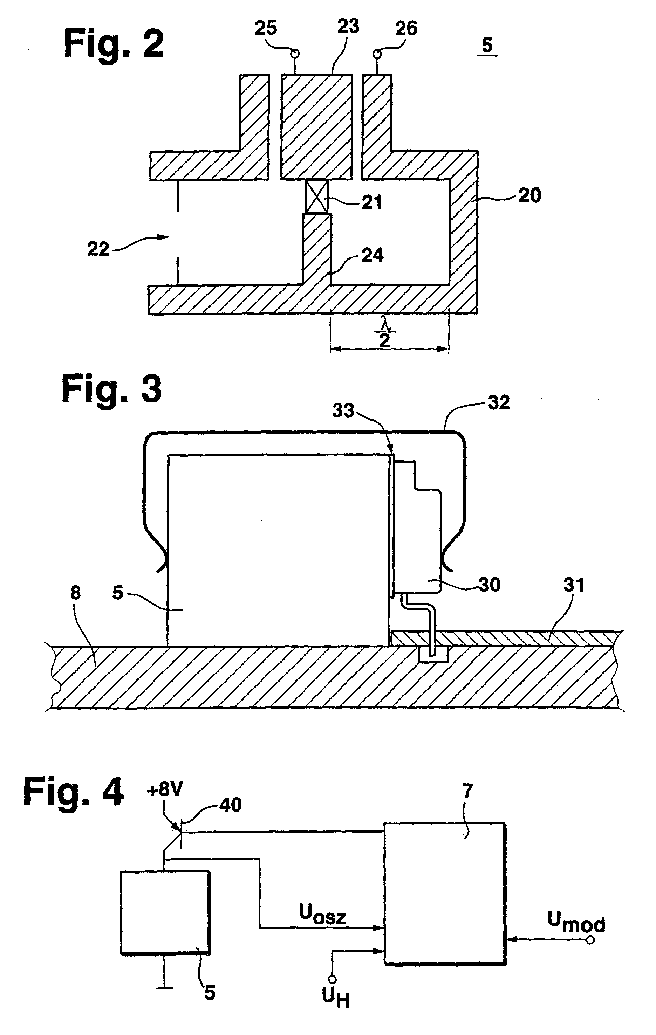

Bei dem genannten Radarsensor liegt der Oszillator 5 gemäß Figur 4 in Reihe zu einem Steuertransistor 40 und bildet mit diesem einen Spannungsteiler. Da bekanntermaßen über die Betriebsspannung Uosz am Oszillator dessen momentane Schwingfrequenz innerhalb gewisser Bereiche beeinflußt werden kann, läßt sich somit über den Transistor sowohl die Frequenzmodulation als auch die Austastung des Oszillators steuern. Während der Austastung liegt dabei üblicherweise keine Spannung am Oszillator an und es fließt dementsprechend kein Strom durch den Spannungsteiler hindurch.

Schwierigkeiten ergeben sich nun, wenn wie in dem vorliegenden Fall der Oszillator eine Mikrowellendiode enthält. Solche auf Halbleiterbauelementen basierende Oszillatoren haben die Eigenschaft, daß sie bei sehr tiefen Temperaturen, insbesondere unterhalb von -20°C , wie sie jedoch bei einem Einsatz in einem Kraftfahrzeug durchaus vorkommen können, nur sehr schlecht oder gar nicht anschwingen. Dies gilt insbesondere, da aufgrund der getakteten Betriebsweise die Eigenerwärmung des Oszillators nicht ausreicht, in diesem Fall ein sicheres und frequenzgenaues Anschwingen zu gewährleisten. Eine mögliche Lösung für diese Schwierigkeit wäre, den Oszillator bei derart tiefen Temperaturen dauerhaft in Betrieb zu nehmen. Dies führt jedoch entweder zu einer höheren Belastung der Umwelt aufgrund der dann insgesamt erhöhten mittleren Sendeleistung oder zu einem erhöhten Aufwand zur Vermeidung dieser erhöhten Belastung. Auch kann die Schwingfrequenz des Oszillators bei diesem Betrieb so weit wegdriften, daß der Frequenzregelkreis nicht mehr in der Lage ist, diese wieder in den zugelassenen Bereich zu ziehen. Somit kann bei diesem Betrieb nicht sicher vermieden werden, daß der Oszillator außerhalb des engbegrenzten, zulässigen Frequenzbandes schwingt.

Eine andere Möglichkeit besteht darin, den Oszillator bei sehr tiefen Temperaturen beispielsweise mit Hilfe eines Heizwiderstandes zu beheizen. Auch dies bedeutet jedoch einen zusätzlichen Schaltungsaufwand und damit verbunden zusätzliche Kosten.

Das Dokument WO 84/01243 beschreibt einen Mikrowellen-Oszillator mit einer Mikrowellendiode. Dabei wird die Wärme zur Erwärmung von der Mikrowellendiode selbst aufgebracht. Das Ansteuerungsprinzip beruht auf zwei verschiedenen Zuständen. Im Zustand zwei, der als "primary mode" bezeichnet wird, wird ein Teil der Energie in Form von elektromagnetischen Wellen abgestrahlt. Im Zustand eins, wird während der Pulspausen eine Spannung angelegt, die zu einem Heizstrom führt. In diesem Fall wird die gesamte der Mikrowellendiode zugeführte Energie in der Mikrowellendiode in Wärme umgesetzt. Zur Ansteuerung wird mittels eines Temperatursensors (48) der Temperaturwert des Mikrowellen-Oszillators (18) an einen Computer (32) übertragen, der die aktuellen Meßwerte mit Daten aus einem ROM (36) vergleicht. In Abhängigkeit davon, wie die aktuelle Temperatur des Mikrowellenoszillators ist und wann der nächste Sendeimpuls erwartet wird, steuert der Computer (32) über eine Spannungsversorgung (44) den Mikrowellen-Oszillator (18) in den bereits genannten Zuständen 1 oder 2 an.

### Aufgabe, Lösung und Vorteile der Erfindung

Ziel der vorliegenden Erfindung ist es, ein Kraftfahrzeug-Radarsystem anzugeben, bei dem auf einfache und vor allem kostengünstige Weise gewährleistet ist, daß der Oszillator auch bei sehr tiefen Temperaturen und bei getakteter Betriebsweise sicher und zuverlässig anschwingt.

Erfindungsgemäß wird diese Aufgabe durch ein Radarsystem gelöst, bei dem wenigstens eins der Bauelemente ohmscher Widerstand, Transistor oder IC-Körper so angeordnet ist, daß es den gehäuseartigen Körper oder ein mit diesem thermisch verbundenes Element berührt, wobei das genannte Bauelement innerhalb der Schaltungsanordnung des Radarsystems wenigstens eine weitere Funktion als die Erzeugung von Wärme besitzt. Gegebenenfalls kann sich zur elektrischen Isolierung zwischen dem genannten Bauelement und dem gehäuseartigen Körper oder dem mit diesem thermisch verbundenen Element eine elektrisch isolierende Wärmeleitfolie, -paste oder Vergleichbares befinden. Dies sei, da es letztlich nur darauf ankommt, daß das jeweilige Bauelement mit dem Oszillator thermisch verkoppelt ist, in der oben genannten Formulierung mit enthalten. Das mit dem gehäuseartigen Körper thermisch verbundene Element kann beispielsweise eine Hohlleiterfortführung des Oszillators oder eine Wärmesenke (Heat Sink) sein.

Besonders vorteilhaft ist es, wenn das genannte Bauelement an dem gehäuseartigen Körper oder dem mit ihm thermisch verbundenen Element befestigt ist.

Bei dem genannten Bauelement handelt es sich um einen Transistor, der als Stellmittel zur Einstellung der Größe des Ansteuersignals des Oszillators dient.

Weitere bevorzugte Ausführungen der Erfindung ergeben sich aus den untergeordneten Ansprüchen sowie den nachfolgend beschriebenen Ausführungsbeispielen.

Vorteil des erfindungsgemäßen Radarsystems ist, daß die Eigenerwärmung des Oszillators auf sehr kostengünstige Weise verstärkt wird, da keine zusätzlichen Bauelemente oder Schaltungsmaßnahmen benötigt werden. Außerdem wird keine zusätzliche Heizenergie benötigt, so daß die Leistungsaufnahme des erfindungsgemäßen Radarsystems gegenüber bekannten Systemen unverändert ist. Trotzdem ist aufgrund der Erfindung ein zuverlässiges und frequenzgenaues Anschwingen des Oszillators auch bei sehr tiefen Temperaturen gewährleistet. Gegenüber einem alternativ denkbaren Dauerbetrieb des Oszillators bei sehr tiefen Temperaturen ist die mittlere abgestrahlte Mikrowellenleistung deutlich reduziert.

Weiterhin besteht die Möglichkeit, den Oszillator bei sehr tiefen Temperaturen bereits zu beheizen, wenn das Radarsystem selbst noch nicht in Betrieb genommen ist, beispielsweise weil der Fahrer die damit verbundene Funktion noch nicht benötigt. Vorteilhafterweise wird bei sehr tiefen Temperaturen der Oszillator, wie anhand der nachfolgenden Ausführungsbeispiele genauer beschrieben, beheizt, sobald der Motor gezündet wird. Die Inbetriebnahme des Radarsystems wird jedoch erst dann zugelassen, wenn die mindestens notwendige Betriebstemperatur des Oszillators erreicht ist. Dies dauert bei der hier vorgeschlagenen Lösung nur ca. 1 bis 2 Minuten.

### Beschreibung von Ausführungsbeispielen

Nachfolgend werden Ausführungsbeispiele der Erfindung anhand einer Zeichnung erläutert. Es zeigen
Figur 1 eine Skizze des Radarsystems gemäß dem Stand der Technik,
Figur 2 einen bekannten Aufbau eines Oszillators mit einer Mikrowellendiode im Querschnitt,
Figur 3 eine bevorzugte erfindungsgemäße Anordnung eines Transistors und
Figur 4 eine Schaltungsanordnung gemäß einem bevorzugtem Ausführungsbeispiel der Erfindung.

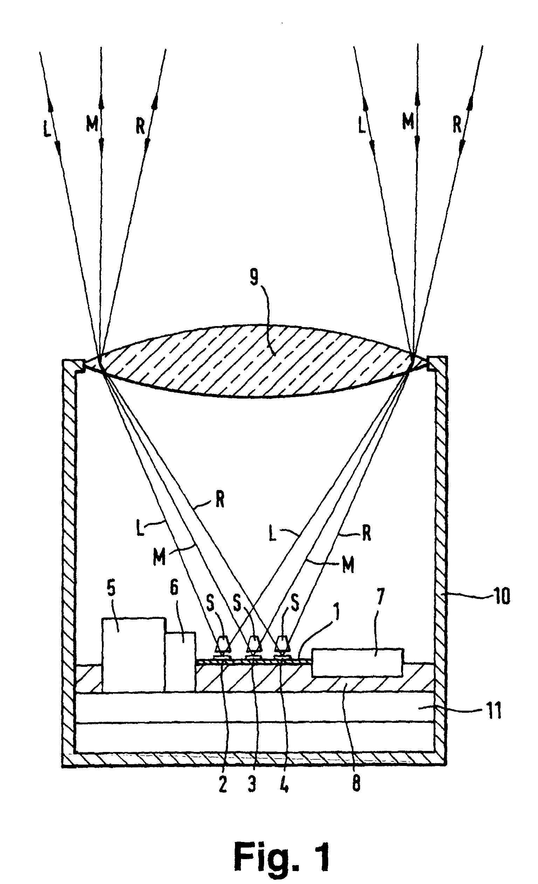

Figur 1 zeigt die Skizze eines Radarsystems gemäß dem oben genannten Stand der Technik. Auf einer Streifenleiteranordung 1 befinden sich drei Sende-/Empfangselemente 2, 3, 4, die in Verbindung mit einer dielektrischen Linse 9 drei Sende-/Empfangskeulen L, M, R ausbilden. Die Streifenleiteranordnung 1 ist auf einem Substrat 8 aufgebracht, welches wiederum auf einer Basisplatte 11 angeordnet ist. Mit 5 ist ein Oszillator bezeichnet, dessen Aufbau anhand Figur 2 ausführlicher beschrieben wird. Mit 6 ist ein sogenannter Stufentransformator bezeichnet. Dies ist eine Hohlleiteranordnung mit einem sich verengenden Querschnitt zur Überkopplung der Mikrowellenenergie des Oszillators 5 auf die Streifenleiteranordnung 1. Mit 7 ist ein Frequenzregelnetzwerk bezeichnet, mit dem die Momentanfrequenz des Oszillators 5 einstellbar ist. Dies wird benötigt, da es sich bei diesem beschriebenen Radarsystem um ein FMCW-Radar handelt. Die Erfindung kann jedoch unabhängig davon auch bei einem Pulsradar Anwendung finden. Die gesamte Schaltungsanordnung des Radarsystems ist in einem Gehäuse 10 untergebracht, das in Strahlrichtung nach vorne durch eine dielektrische Linse 9 abgeschlossen ist.

Figur 2 zeigt einen bekannten Aufbau des Oszillators 5, wie er beispielsweise in "Handbuch für Hochfrequenz- und Elektrotechniker", Band 5, herausgegeben von Curt Rind im Hüthig-Verlag, Heidelberg ausführlicher beschrieben ist. Dabei befindet sich eine Mikrowellendiode, vorzugsweise eine Gunn- oder Impattdiode 21 innerhalb einer Resonanzanordnung 20. Die Resonanzanordnung 20 ist eine Hohlleiterstruktur, deren geometrische Abmessungen die Resonanzfrequenz des Oszillators bestimmt. Zur Auskopplung der erzeugten Mikrowellenenergie ist eine Öffnung 22 vorgesehen, die im vorliegenden Fall an den Stufentransformator 6 angekoppelt wird. Alternativ sind jedoch auch andere bekannte Auskopplungsarten, beispielsweise eine magnetische Auskopplung mit Hilfe einer Leiterschleife denkbar. Die Mikrowellendiode 21 sitzt auf einem in diesem Fall zylindrischen Metallpfosten, der sich in der Mitte der Resonanzanordnung 20 befindet. Mit ihrem oberen Ende berührt sie einen metallischen Block 23.

Dieser dient als Wärmesenke oder Kühlkörper, da die Mikrowellendiode bei normalen Umgebungstemperaturen und insbesondere bei einem Dauerbetrieb sehr heiß werden kann. Über zwei Anschlüsse 25 und 26 an dem metallischen Block 23 und der Resonanzanordnung 20 ist der Mikrowellendiode 21 eine Betriebsspannung zuführbar. Überschreitet diese Betriebsspannung einen Schwellwert, dessen Größe von dem verwendeten Diodentyp abhängt, wird innerhalb der Resonanzanordnung 20 eine Hochfrequenzschwingung angeregt, deren Frequenz im wesentlichen durch die geometrischen Abmessungen der Anordnung bestimmt ist. Durch Variation der Größe der Versorgungsspannung kann die Frequenz jedoch innerhalb eines bestimmten Bereichs verändert werden. Dies wird bei einem FMCW-Radar vorteilhafterweise zur Frequenzmodulation verwendet. Unterschreitet die Betriebsspannung den genannten Schwellwert, klingt die angeregte Schwingung wieder ab, das heißt der Oszillator 5 hört auf zu schwingen. Im Taktbetrieb wird zur Austastung des Oszillators die Versorgungsspannung üblicherweise auf Null gesetzt.

Figur 3 zeigt eine bevorzugte erfindungsgemäße Anordnung eines Transistors zur Ergänzung der Eigenerwärmung des Oszillators 5. Alternativ könnte hier anstelle des Transistors ein ohmscher Widerstand, ein Integrierter Schaltkreis (IC) oder auch ein anderes Bauelement verwendet werden. Wesentlich ist, daß es sich hier um ein Bauelement handelt, das im Betrieb eine meßbare und für den genannten Zweck ausreichende Eigenerwärmung aufweist. Gezeigt ist der Oszillator 5 mit seinem gehäuseartigen Körper auf der Basisplatte 8 gemäß Figur 1. Mit 31 ist eine Leiterbahn bezeichnet, die beispielsweise mit dem Transistor 30 kontaktiert ist. Der Transistor 30 berührt den Oszillator 5 und ist dementsprechend thermisch mit diesem gekoppelt. Unter Umständen genügt es sogar, daß das jeweilige Bauelement nur "sehr dicht" bei dem Oszillator 5 angeordnet ist, ohne ihn direkt zu berühren. Dies hängt im Einzelfall von der abgegebenen Verlustleistung des Bauelements ab. Gemäß einer bevorzugten Ausführung ist der Transistor 30 jedoch an dem gehäuseartigen Körper des Oszillators 5 befestigt. Dies kann gemäß Figur 3 beispielsweise über eine Federklammer 32 realisiert sein. Alternativ kann der Transistor 30 jedoch an das Gehäuse des Oszillators 5 geschraubt sein. Zur elektrischen Entkopplung zwischen dem Oszillator 5 und dem Transistor 30 ist hier eine elektrisch isolierende Schicht 33 zwischen dem Oszillator 5 und dem Gehäuse des Transistors 30 vorgesehen. Solche isolierenden Schichten in Form von Wärmeleitfolien oder -pasten sind im Stand der Technik hinreichend bekannt.

Figur 4 zeigt eine Schaltungsanordnung eines besonders bevorzugten Ausführungsbeispiels der Erfindung. Als schematische Blöcke sind der Oszillator 5 sowie das Frequenzregelnetzwerk 7 aus Figur 1 gezeigt. Weiterhin ist ein Transistor 40 vorhanden, dessen Emitter an einer Spannung von in diesem Fall +8 V liegt. Die Basis des Transistors ist mit dem Frequenzregelnetzwerk 7 verbunden. Über seinen Kollektor ist der Transistor mit dem Oszillator 5, beispielsweise mit dem Anschluß 25 gemäß Figur 2 verbunden. Der zweite Anschluß 26 liegt in diesem Fall an Masse. Der Transistor 40 und der Oszillator 5 bilden bezüglich der Spannung von +8 V einen Spannungsteiler. Dadurch kann über das Frequenzregelnetzwerk 7 und den Transistor 40 die Betriebsspannung Uosz am Oszillator 5 eingestellt werden. Die jeweils aktuelle Betriebsspannung Uosz wird parallel zum Oszillator 5 vom Kollektor des Transistors 40 abgegriffen und dem Frequenzregelnetzwerk 7 zugeführt.

Weiterhin erhält das Frequenzregelnetzwerk 7 an weiteren Eingängen ein erstes Steuersignal Umod sowie ein zweites Steuersignal UH. Beide werden von einer nicht dargestellten zentralen Steuereinheit des Radarsystems erzeugt. In Abhängigkeit des Steuersignals Umod erzeugt das Frequenzregelnetzwerk 7 eine Steuerspannung, die an die Basis des Transistors 40 gelangt, und bestimmt somit über die Basis des Transistors 40 die Betriebsspannung des Oszillators 5. Da diese wie erwähnt innerhalb gewisser Grenzen die Momentanfrequenz des Oszillators beeinflußt, kann so die Frequenz des Oszillators 5 moduliert werden. Das zweite Steuersignal UH ist vorzugsweise ein logisches Signal, das gemäß der besonders bevorzugten Ausführung der Erfindung zu einer schaltbaren Beheizung des Oszillators 5 dient. Dazu wird in Abhängigkeit dieses Signals die Betriebsspannung Uosz des Oszillators in den Zeitabschnitten, in denen der Oszillator keine Schwingung erzeugen soll, nicht auf Null, sondern auf einen Wert eingestellt, der zwischen einem ersten und einem zweiten Schwellwert liegt, wobei ein Überschreiten des ersten Schwellwertes bewirkt, daß ein Stromfluß durch den Spannungsteiler entsteht und wobei erst ein Überschreiten des zweiten Schwellwertes bewirkt, daß der Oszillator anfängt zu schwingen. Bei einem Oszillator mit einer Gunndiode liegt der erste Schwellwert beispielsweise bei 0 V und der zweite bei ca. 0,8 V.

Durch die gegenüber dem Normalfall erhöhte Betriebsspannung Uosz während der Zeitabschnitte der Austastung des Oszillators entsteht ein insgesamt erhöhter mittlerer Stromfluß durch den Oszillator 5, was zu einer erhöhten Eigenerwärmung des Oszillators 5 führt. Bei sehr tiefen Temperaturen reicht dies jedoch allein noch nicht, um die eingangs gestellte Aufgabe zu lösen. Dies ergibt sich rechnerisch daraus, daß in den Zeitabschnitten, in denen der Oszillator nicht schwingt, die Betriebsspannung Uosz unterhalb des zweiten Schwellwertes liegen muß. Dadurch fällt der Großteil der Spannung (ca. 7 V) an dem Transistor 40 ab und es wird in ihm auch der Großteil der Verlustleistung umgesetzt. Durch die erfindungsgemäße Anordnung des Transistors gemäß Figur 3 wird der Transistor jedoch thermisch mit dem Oszillator gekoppelt und dem Oszillator so zusätzliche Verlustleistung zur Beheizung zugeführt. Wird beispielsweise bei höheren Umgebungstemperaturen keine zusätzliche Beheizung oder Erwärmung des Oszillators benötigt, wird in Abhängigkeit des Steuersignals UH während der Zeitabschnitte, in denen der Oszillator ausgetastet ist, der Stromfluß durch den Spannungsteiler aus dem Transistor 40 und dem Oszillator 5 vollkommen unterbunden. Dadurch findet keine zusätzliche Erwärmung statt und die Anordnung verhält sich ebenso wie die im Stand der Technik bekannten Anordnungen. Dementsprechend ist die hier beschriebene Kombination der Anordnungen gemäß den Figuren 3 und 4 zur Lösung der gestellten Aufgabe besonders vorteilhaft.

Werden der zentralen Steuereinheit mittels eines nicht dargestellten Temperatursensors Informationen über die aktuelle Temperatur des Oszillators zugeführt, kann über die Länge der Austastzeiten und über die Höhe der Betriebsspannung während der Austastzeiten die Temperatur des Oszillators in einfacher und damit vorteilhafter Weise geregelt werden. Durch eine solche Temperaturregelung werden Frequenzschwankungen des Oszillators reduziert, die aus einer temperaturbedingten Verschiebung des Arbeitspunktes der Mikrowellendiode folgen.

Im Prüfungsverfahren der deutschen Prioritätsanmeldung wurden zum Stand der Technik folgende weitere Dokumente genannt:
1) DE 32 22 900 C2
2) US 4,445,096

## Patentansprüche

1. Kraftfahrzeug-Radarsystem, mit einem Oszillator (5),
- der während des Betriebs des Radarsystems in Abhängigkeit eines Ansteuersignals nur zeitabschnittsweise ein Hochfrequenzsignal erzeugt und
- der eine Mikrowellendiode (21), insbesondere eine Gunn- oder Impattdiode umfaßt, die innerhalb eines gehäuseartigen Körpers (20) untergebracht ist,
- wobei ein Transistor als Stellmittel zur Einstellung der Größe des Ansteuersignals des Oszillators dient,
**dadurch gekennzeichnet,**
- **daß** der Transistor innerhalb der Schaltungsanordnung des Radarsystems wenigstens eine weitere technische Funktion besitzt außer als Stellmittel zur Einstellung der Größe des Ansteuersignals des Oszillators zu dienen,
- **daß** diese weitere technische Funktion die Erzeugung von Wärme ist und
- **daß** der Transistor so angeordnet ist, daß er mit dem gehäuseartigen Körper des Oszillators direkt oder indirekt thermisch verkoppelt ist.

2. Radarsystem nach Anspruch 1, **dadurch gekennzeichnet, daß** das genannte Bauelement den gehäuseartigen Körper des Oszillators oder ein mit diesem thermisch verbundenes Element berührt.

3. Radarsystem nach Anspruch 1 oder 2, **dadurch gekennzeichnet, daß** das Bauelement an dem gehäuseartigen Körper befestigt ist.

4. Radarsystem nach Anspruch 1, **dadurch gekennzeichnet, daß** der Transistor mit dem Oszillator in Reihe geschaltet ist, so daß die beiden einen Spannungsteiler bilden, und daß mit Hilfe des Transistors die Betriebsspannung des Oszillators auf wenigstens einen Wert einstellbar ist, der oberhalb eines ersten und unterhalb eines zweiten Schwellwerts liegt, wobei ein Überschreiten des ersten Schwellwertes bewirkt, daß ein Stromfluß durch den Spannungsteiler entsteht und wobei ein Überschreiten des zweiten Schwellwertes bewirkt, daß der Oszillator anfängt zu schwingen.

5. Radarsystem nach Anspruch 4, **dadurch gekennzeichnet, daß** über die Länge von Austastzeiten und über die Höhe der Betriebsspannung während der Austastzeiten die Temperatur des Oszillators regelbar ist.

## Claims

1. Motor vehicle radar system, having an oscillator (5),
- which produces a radio-frequency signal only at times as a function of a drive signal during the operation of the radar system, and
- which has a microwave diode (21), in particular a Gunn or Impatt diode, which is accommodated within a housing-like body (20),
- with a transistor being used as actuating means for setting the magnitude of the drive signal for the oscillator,
**characterized**
- **in that** the transistor has at least one further technical function within the circuit arrangement of the radar system, in addition to being used as an actuating means for setting the magnitude of the drive signal for the oscillator,
- **in that** this further technical function is the production of heat, and
- **in that** the transistor is arranged such that it is directly or indirectly thermally coupled to the housing-like body of the oscillator.

2. Radar system according to Claim 1, **characterized in that** said component touches the housing-like body of the oscillator, or an element which is thermally connected to it.

3. Radar system according to Claim 1 or 2, **characterized in that** the component is mounted on the housing-like body.

4. Radar system according to Claim 1, **characterized in that** the transistor is connected in series with the oscillator, such that the two form a voltage divider, and **in that** the operating voltage of the oscillator can be set by means of the transistor to at least one value which is above a first and below a second threshold value, with overshooting of the first threshold value resulting in a current flowing through the voltage divider, and with overshooting of the second threshold value resulting in the oscillator starting to oscillate.

5. Radar system according to Claim 4, **characterized in that** the temperature of the oscillator can be regulated via the length of the blanking times and via the magnitude of the operating voltage during the blanking times.

## Revendications

1. Système de radar de véhicule automobile comportant un oscillateur (5)
- qui pendant le fonctionnement du système de radar génère, en fonction d'un signal de commande, un signal haute fréquence seulement par segments de temps et
- qui comporte une diode hyperfréquence (21), notamment une diode Gunn ou Impatt, logée à l'intérieur d'un boîtier (20),
- avec un transistor prévu comme moyen de réglage pour régler l'amplitude du signal de commande de l'oscillateur,
**caractérisé en ce que**
- le transistor possède à l'intérieur du circuit du système radar, au moins une autre fonction technique en dehors de celle de moyen de réglage pour régler l'amplitude du signal de commande de l'oscillateur,
- l'autre fonction technique consiste à dégager de la chaleur et
- le transistor est installé de manière à être couplé directement ou indirectement du point de vue thermique au boîtier de l'oscillateur.

2. Système de radar selon la revendication 1,
**caractérisé en ce que**
le composant touche le boîtier de l'oscillateur ou un élément relié thermiquement à celui-ci.

3. Système de radar selon l'une quelconque des revendications 1 ou 2,
**caractérisé en ce que**
le composant est fixé au boîtier.

4. Système de radar selon la revendication 1,
**caractérisé en ce que**
le boîtier est branché en série avec l'oscillateur pour que ces deux éléments constituent un diviseur de tension et
à l'aide du transistor on règle la tension de fonctionnement de l'oscillateur selon au moins une valeur située au-dessus d'un premier seuil et en dessous d'un second seuil,
en cas de dépassement du premier seuil, on a le passage d'un courant à travers le diviseur de tension et en cas de dépassement vers le haut du second seuil, l'oscillateur commence à osciller.

5. Système de radar selon la revendication 4,
**caractérisé en ce qu'**
on règle la température de l'oscillateur par la longueur des durées de détection et par l'amplitude de la tension de fonctionnement pendant les durées de détection.
